# EUROPÄISCHE PATENTSCHRIFT

(11) **EP 1 365 045 B1**
(45) Veröffentlichungstag und Bekanntmachung des Hinweises auf die Patenterteilung: **23.07.2008**
(21) Anmeldenummer: 03010865.8
(22) Anmeldetag: 15.05.2003
(51) Int. Cl.: C23C 30/00, C23C 16/30

(54) **TiBN-Beschichtung**
TiBN coating
Revêtement en TiBN

(30) Priorität: 21.05.2002 DE 10222347
(43) Veröffentlichungstag der Anmeldung: 26.11.2003
(73) Patentinhaber: WALTER Aktiengesellschaft, 72072 Tübingen (DE)
(72) Erfinder: Holzschuh, Helga, 72537 Mehrstetten (DE)
(74) Vertreter: Rüger, Barthelt & Abel Patentanwälte

(56) Entgegenhaltungen:
- AT-B- 387 988
- DE-A- 10 120 046
- FR-A- 2 370 551
- US-A- 5 851 680
- MOLLART, T. P. ET AL: "Tribological behavior of homogeneous Ti-B-N, Ti-B-N-C and TiN/h-BN/TiB2 multilayer coatings" SURFACE AND COATINGS TECHNOLOGY (1996), 86-87(1-3), 231-236 , 1996, XP002253566

## Beschreibung

Die Erfindung betrifft einen Schneideinsatz oder ein Schneidwerkzeug, insbesondere zur spanenden Werkstückbearbeitung, sowie ein Verfahren zur Herstellung einer an diesem Schneidwerkzeug vorzusehenden Beschichtung.

Hartstoffschichten zur Verschleißminderung, zur Reibungsminderung oder zu ähnlichen Zwecken, sind in unterschiedlichen Zusammensetzungen und Herstellungsverfahren bekannt. Insbesondere sind Titanbornitrid-Schichten (TiBN-Schichten) bekannt. Die DE 43 43 354 A1 offenbart dazu die Herstellung einer TiBN-Schicht im PVD-Verfahren. Die TiBN-Schicht entsteht durch PVD-Verdampfung von Titanborid bei einer Beschichtungstemperatur von etwa 200°C. Die Abscheidung von Titanborid erfolgt aus einem Beschichtungsplasma heraus.

Es ist schwierig, die PVD-Erzeugung einer TiBN-Schicht in einen Prozess zu integrieren, der sonstige Schichten im CVD-Verfahren erzeugt.

Aus der EP 0 732 423 B1 sind Schichtstrukturen bekannt, die TiBN-Schichten enthalten. Die TiBN-Schichten sind als Zwischenschichten zwischen anderen Schichten zur Haftungsverbesserung vorgesehen. Die Schichten werden bei einer Abscheidungstemperatur von 1000°C im CVD-Verfahren erzeugt.

Weiter ist aus Bartsch, Leonhardt, Wolf "Composition Oscillations in Hard Material Layers Deposited from the Vapour Phace", Journal de Physique IV, Colloque C2, suppl. au Journal de Physique II, Vol. 1, septembre 1991, die Erzeugung von einer TiBN-Schicht bekannt, die aus den geschichteten Komponenten TiNₓ und TiB₂ besteht. Zur Erzeugung dieser oszillierenden Schichten ist die Beschichtung in einem Kaltwandreaktor bei einer Temperatur von 1300 K (etwa 1000°C) im CVD-Verfahren vorgenommen worden.

Aus der AT 387 988 B ist ein Verfahren zur Herstellung mehrlagiger Beschichtungen von Hartmetallteilen bekannt. Das Verfahren beruht auf einem CVD-Prozess, mit dem auf einen Wolframkarbitgrundkörper eine Metall-Bornitrid-Schicht aufgebracht wird. Die Borkonzentration in der Metall-Bornitrid-Schicht wird unterhalb desjenigen "Grenzwerts gehalten, bei dem erstmals zusätzlich zu der homogenen Bornitrid-Mischkristallphase eine Diboridphase auftritt.

Es ist Aufgabe der Erfindung einen Schneidkörper anzugeben, der mit einer sehr harten Beschichtung versehen ist. Außerdem ist es Aufgabe der Erfindung, ein Verfahren zur Herstellung solcher harten Schichten anzugeben.

Diese Aufgabe wird durch einen Schneidkörper mit den Merkmalen des Patentanspruchs 1, sowie ein Verfahren nach Anspruch 17 gelöst.

Der erfindungsgemäße Schneidkörper weist einen Grundkörper mit einer Beschichtung auf, die durch eine TiBN-Schicht gebildet ist oder eine solche Schicht enthält, die einen Borgehalt von ≥6 At% aufweist. Eine solche Schicht kann eine Härte von über 4500 HV100 erreichen. Zusätzlich zeigt sich, dass eine solche Schicht auch auf kohlenstoffhaltigen Grundmaterialien, wie Wolframkarbid, oder anderen Schichten, die von Kohlenstoff aus dem Grundmaterial durchdrungen werden können, gut haftet. Es lassen sich somit Schneideinsatz oder Schneidwerkzeuge mit besten Zerspanungseigenschaften schaffen.

Vorzugsweise ist die TiBN-Schicht eine Mischphasen-schicht aus TiN und TiB₂. Beispielsweise besteht die Mischphasenschicht aus einem kubischen TiN-Grundgitter, in das TiB₂-Kristalle eingelagert sind. Hiermit werden Haftungsprobleme in Folge von Kohlenstoffdiffusion aus einem Hartmetall, wie Wolframkarbid, in die Beschichtung unterbunden. Diffundiert Bor aus der abgeschiedenen Schicht in das Hartmetall und führt dies zur Bildung von CoWB, kann der frei werdende Kohlenstoff von dem kubischen TiN-Gitter aufgenommen werden, ohne Haftungsprobleme zu verursachen.

Die TiBN-Schicht kann auch so hohe Borgehalte aufweisen, dass sie eine TiB₂-Schicht mit eingelagerten TiN-Kristallen ist. Hier lassen sich besonders hohe Härten erzielen.

Bevorzugterweise ist die TiBN-Schicht so zusammengesetzt dass die Hälfte oder etwas mehr als die Hälfte des Anteils der Mischphase als TiB₂ vorliegt, während der verbleibende Teil als TiN vorliegt. Der TiN-Anteil stellt eine gute Unempfindlichkeit gegen diffundierenden Kohlenstoff sicher, der insbesondere bei höheren Beschichtungstemperaturen mobilisiert wird.

Die Schichten werden vorzugsweise in einem CVD-Verfahren abgeschieden. Damit lässt sich die TiBN-Schicht in einen Schichtaufbau integrieren, der insgesamt im CVD-Verfahren erzeugt wird. Es können herkömmliche CVD-Anlagen angewendet werden. Mittel zur Plasmaerzeugung oder zur Targetverdampfung sind nicht erforderlich. Die TiBN-Schicht kann direkt auf einem Wolframkarbidgrundmaterial aufgebracht sein. Kohlenstoffdiffusion stört die Haftung nicht, wenn die aufgebrachte Schicht ein kubisches TiN-Gitter enthält. Die TiBN-Schicht kann außerdem auf einer Aluminiumoxidschicht aufgebracht sein. Sie kann hier als Deckschicht dienen. Versuche haben gezeigt, dass ein Schichtaufbau mit einer Deckschicht TiBN auf α-Aluminiumoxid bei Drehwerkzeugen zur Gusszerspanung eine Standzeitverlängerung von 20 % gegenüber Schneidwerkzeugen mit einer TiN-bedeckten α-Aluminiumoxidschicht ohne TiBN-Beschichtung ergibt. Durch Variation der Prozessgase kann eine Multilagenbeschichtung erzielt werden, in der sich dünne TiN-Lagen mit TiBN-Lagen abwechseln. Diese Schichten zeigen überlegene Zerspanungseigenschafte. Insbesondere sind solche Schichten kaum kammrissanfällig. Dies wird auf die Abwechslung von weicheren TiN-Lagen mit härteren TiBN-Lagen zurückgeführt. Es können bis zu 50 Lagen pro µm Schichtdicke vorgesehen werden.

Das erfindungsgemäße Verfahren ist ein CVD-Verfahren, bei dem eine niedrige Prozesstemperatur von 700°C bis 950°C, z.B. bei 850°C. Die Prozessatmosphäre enthält Precursoren für Titan und Bor sowie Stickstoff und/oder Stickstoffverbindungen. Die Abscheidungsrate von Titanbornitrid ist dabei höher als die Abscheidungsraten von Titannitrid oder Titanborid jeweils für sich. Dies ermöglicht die CVD-Abscheidung bei relativ niedriger Temperatur. Die niedrige Temperatur hat lediglich geringe Kohlenstoffdiffusionsraten zur Folge, was ein glattes ansprechendes Aussehen der Schicht ergibt.

Als Precursor für Titan wird vorzugsweise TiCl₄ vorgesehen. Als Precursor für Bor kommt vorzugsweise BCl₃ zur Anwendung. Als Anteile an der Prozessatmosphäre werden vorzugsweise 0,9 bis 1,5 Vol% TiCl₄ und 0,09 bis 2,5 Vol% BCl₃ festgelegt. Der Stickstoffgehalt der Prozessatmosphäre beträgt vorzugsweise 14 bis 17 Vol%. Der verbleibende Rest der Prozessatmosphäre ist vorzugsweise Wasserstoff.

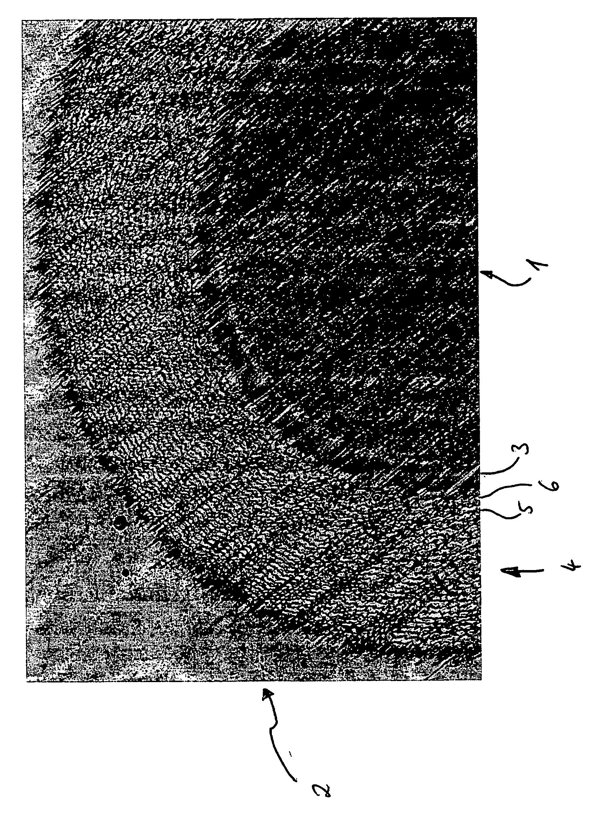

Weitere Einzelheiten vorteilhafter Ausführungsformen der Erfindung ergeben sich aus der nachfolgenden Beschreibung sowie Unteransprüchen. Ein besonders bevorzugtes Ausführungsbeispiel ist in der einzigen Figur dargestellt.

### Beispiel 1:

Auf einem Schneidkörper aus Wolframkarbid wird zunächst in einem CVD-Prozess eine TiN-Schicht von beispielsweise 0,5 µm Dicke aufgebracht. Dazu wird der Schneidkörper in einen CVD-Reaktor gebracht und der entsprechende CVD-Prozess durchgeführt. Nach Abscheidung der TiN-Schicht wird der Reaktor bei einer Abscheidetemperatur von 850°C mit einer Atmosphäre gefüllt, die 1 Vol% TiCl₄, 16 Vol% N₂, 0,1 Vol% BCl₃ und den Rest H₂ enthält. Es wird ein Prozessdruck von 100 Millibar eingestellt. Nach einer Prozessdauer von 15 Stunden hat sich eine 6 µm dicke TiBN-Schicht mit metallisch messinggelber Farbe abgeschieden. Die TiBN-Schicht ist eine TiN-Matrix, in die TiB₂-Kristallite eingelagert sind. Die Mikrohärte kann über 4500 HV liegen.

### Beispiel 2:

Der Borgehalt der TiBN-Schicht kann durch Erhöhung des BCl₃-Gehalts der Prozessatmosphäre gesteigert werden. Beispielsweise wird ein Schneidkörper in einem CVD-Reaktor und in einem CVD-Prozess zunächst mit einer 0,5 µm dicken TiN-Schicht versehen. Danach wird eine Prozessatmosphäre mit 1 Vol% TiCl₄, 16 Vol% N₂, 2,5 Vol% BCl₃ und den verbleibenden Prozentanteilen Wasserstoff eingestellt und bei einem Prozessdruck von 100 Millibar und einer Abscheidetemperatur von 850°C ein Beschichtungsprozess durchgeführt. Nach drei Stunden ist eine silbern aussehende TiBN-Schicht von 6 µm Dicke aufgewachsen. Diese besteht aus einer TiB₂-Matrix, in die TiN-Kristalle oder Kristallite eingelagert sind. Kann die Diffusion von Kohlenstoff in die TiBN-Schicht gering gehalten werden, wird eine hohe Härte und Verschleißfestigkeit erreicht.

Bedarfsweise kann der Prozessdruck in dem Bereich von 60 bis 950 Millibar eingestellt werden. Die Temperatur beeinflusst die Abscheidungsrate. Prinzipiell ist das Temperaturband von 700°C bis 1050°C nutzbar. Der BCl₃-Gehalt der Prozessatmosphäre wird zwischen 0,05 und 5 Vol% eingestellt.

### Beispiel 3:

Zur Herstellung eines Schneidkörpers, beispielsweise zur Stahlzerspanung wird dieser in einem CVD-Reaktor zunächst mit einer TiN-Schicht von 0,5 µm Dicke beschichtet. Im zweiten Schritt wird eine Mitteltemperatur TiCN-Schicht von 8 µm Dicke aufgebracht (Prozesstemperatur = 700-900°C). Das Verfahren läuft im gleichen Reaktor ab. Im dritten Schritt wird im gleichen Reaktor im CVD-Verfahren eine TiAlCNO-Schicht von 0,8 µm Dicke aufgebracht. Diese dient als Bindungsschicht für eine im vierten Schritt darüber abzulagernde Al₂O₃-Schicht von 6 µm Dicke. Nach Ablauf dieser vier CVD-Beschichtungsschritten in ein und demselben Reaktor wird im fünften Schritt eine 2 µm dicke TiBN-Schicht aufgebracht. Bei einem Prozessdruck von 300 Millibar, einer Abscheidetemperatur von 850°C und einer Prozessatmosphärenzusammensetzung von 1 Vol% TiCl₄, 16 Vol% N₂, 0,1 Vol% BCl₃ und dem Rest H₂ ist die 2 µm dicke Schicht in 270 Minuten aufgewachsen. Die Schicht ist eine Titannitridmatrix mit eingelagerten TiB₂-Kristallen. Die Schicht sieht metallisch messinggelb aus.

### Beispiel 4:

Wie im vorstehend beschriebenen Beispiel kann ein Schneidkörper zunächst mit einer TiN-Schicht von 0,5 µm Dicke, einer NT-TiCN-Schicht von 8 µm Dicke, einer Bindungsschicht, z.B. TiAlCNO, von 8 µm Dicke und einer Aluminiumoxidschicht (Al₂O₃) von 6 µm Dicke beschichtet werden. Im gleichen Reaktor kann dann eine TiBN-Schicht von 2 µm Dicke aufgebracht werden. Bei einem Prozessdruck von 600 Millibar und einer Abscheidetemperatur von 900°C, sowie einer Prozessatmosphäre mit 1,4 Vol% TiCl₄, 15 Vol% N₂, 0,15 Vol% BCl₃ und dem Rest H₂ ergibt sich eine 2 µm dicke Schicht nach 150 Minuten Beschichtungszeit. Die Schicht weist einen metallisch hellen Gelbton auf.

Der Prozessdruck kann zwischen 60 und 950 Millibar festgelegt sein. Die Abscheidetemperatur kann in dem Bereich von 700°C bis 1050°C festgelegt sein. Der BCl₃-Gehalt der Prozessatmosphäre liegt zwischen 0,05 Vol% und 5 Vol%.

Als Beschichtung insbesondere für Schneidkörper ist eine TiBN-Schicht vorgesehen, die eine Mischphase aus TiN und TiB₂ ist. Der Borgehalt ist ≥6 At%. Die Abscheiderate ist höher als die einer TiN-Schicht und auch höher als die einer TiB₂-Schicht. Es werden Härten von über 4000 HV erreicht.

In der einzigen Figur ist eine Schneidplatte ausschnittsweise veranschaulicht, deren Oberfläche durch einen kugelkalottenförmigen Schleifkörper angeschliffen worden ist. Der Anschliff zeigt in der Figur rechts unten einen zentralen grauen Bereich 1, in dem das Grundmaterial (z.B. Wolframcarbid) zu Tage tritt. In dem ungestörten Bereich 2 (links oben) ist die unverletzte Oberfläche zu erkennen, die aus TiBN besteht. Im unmittelbaren Anschluss an das Substrat findet sich eine TiN-Schicht 3 mit einer Dicke von etwa 1 µm. Die darauf liegende Multilagen-Deckschicht 4 weist eine Dicke von etwa 6 µm auf. Sie besteht aus ungefähr 30 Lagen, wobei sich auf einer vergleichsweise dünnen TiN-Lage 5 eine jeweils etwa drei bis fünf mal so dicke TiBN-Lage 6 befindet. Die TiBN-Lagen 6 sind vorzugsweise Mischphasenlagen aus TiN und TiB₂. 50 % bis 60 % der Mischphase liegen als Titandiborid (TiB₂) vor. Die TiN-Lagen 5 sind untereinander vorzugsweise gleich dick. Ebenso sind die TiBN-Lagen 6 vorzugsweise gleich dick. Soweit in der Figur die Dicken unterschiedlich erscheinen, ist dies auf den sphärischen Schliff zurück zu führen.

Bei der Herstellung dieser Multilagenbeschichtung kann die Substrattemperatur unter 900°C gehalten werden. Die Multilagenschicht 4 weist eine ausgezeichnete Haftung und eine extrem glatte Oberfläche auf. Die Anzahl der Einzellagen kann größer als 50 sein. Die Härte entspricht der einer TiBN-Schicht und liegt bei ca. 3.800 HV. Die Eigenspannungen der Schicht sind gering und es zeigt sich insbesondere eine verminderte Anfälligkeit gegen Kammrisse beim Zerspanen von harten und zähen Stählen.

## Patentansprüche

1. Schneidkörper insbesondere zur spanenden Werkstückbearbeitung,
mit einem Grundkörper, der eine Beschichtung aufweist, wobei die Beschichtung wenigstens eine TiBN-Schicht mit einem Bor Gehalt von größer oder gleich 6 at% enthält und wobei die Beschichtung in einem CVD-Prozess mit Temperaturen von 700°C bis 950°C erzeugt worden ist wobei die TiBN-Schicht eine Mischphasen-Schicht nur aus TiN und TiB₂ ist.

2. Schneidkörper nach Anspruch 1, **dadurch gekennzeichnet, dass** der TiB₂-Gehalt der Mischphasen-Schicht zwischen 50Gew.% und 60Gew.% liegt.

3. Schneidkörper nach Anspruch 1, **dadurch gekennzeichnet, dass** die TiBN-Schicht eine TiN-Schicht mit eingelagerten TiB₂-Kristallen ist.

4. Schneidkörper nach Anspruch 1, **dadurch gekennzeichnet, dass** die TiBN-Schicht eine TiB₂-Schicht mit eingelagerten TiN-Kristallen ist.

5. Schneidkörper nach Anspruch 1, **dadurch gekennzeichnet, dass** die TiBN-Schicht auf einem WC-Grundmaterial aufgebracht ist.

6. Schneidkörper nach Anspruch 1, **dadurch gekennzeichnet, dass** die TiBN-Schicht als Deckmaterial eines Schichtaufbaus vorgesehen ist.

7. Schneidkörper nach Anspruch 1, **dadurch gekennzeichnet, dass** die TiBN-Schicht auf eine Al₂O₃-Schicht aufgebracht ist.

8. Schneidkörper nach Anspruch 1, **dadurch gekennzeichnet, dass** der Grundkörper mit einer Mehrschichtigen Beschichtung mit folgender Schichtfolge aufgebaut ist: TiN-TiCN-TiAlCNO-α-Al₂O₃-TiBN.

9. Schneidkörper nach Anspruch 6, **dadurch gekennzeichnet, dass** die TiBN-Schicht die Deckschicht ist.

10. Schneidkörper nach Anspruch 1, **dadurch gekennzeichnet, dass** die TiBN-Schicht eine Multilagenschicht ist, in der sich TiN-Schichten mit TiBN-Schichten abwechseln.

11. Schneidkörper nach Anspruch 10, **dadurch gekennzeichnet, dass** die Gesamtdicke der TiBN-Schicht höchstens 12 µm beträgt und vorzugsweise zwischen 2 µm und 5 µm beträgt.

12. Schneidkörper nach Anspruch 1, **dadurch gekennzeichnet, dass** die TiN-Lagen Multilagenschicht dünner sind als die TiBN-Lagen.

13. Schneidkörper nach Anspruch 3, **dadurch gekennzeichnet, dass** die Dicke der TiN-Lagen höchstens die Hälfte der Dicke der TiBN-Lagen beträgt.

14. Schneidkörper nach Anspruch 1, **dadurch gekennzeichnet, dass** die Multilagenschicht wenigstens 20 Lagen aufweist.

15. Verfahren zur Herstellung einer Hartstoffschicht, insbesondere für einen Schneidkörper, bei dem ein zu beschichtender Körper in einem Reaktor bei einem Prozessdruck zwischen 60 und 950 mbar und einer Temperatur zwischen 700°C und 950°C positioniert wird wobei die Prozessatmosphäre Precursoren für Titan und Bor sowie Stickstoff und/oder Stickstoffverbindungen enthält.

16. Verfahren nach Anspruch 15, **dadurch gekennzeichnet, dass** die Prozesstemperatur unter 850°C liegt.

17. Verfahren nach Anspruch 15, **dadurch gekennzeichnet, dass** die Prozessatmosphäre Wasserstoff (H₂) enthält.

18. Verfahren nach Anspruch 15, **dadurch gekennzeichnet, dass** der Precursor für Titan TiCl₄ ist.

19. Verfahren nach Anspruch 15, **dadurch gekennzeichnet, dass** der Precursor für Bor BCl₃ ist.

20. Verfahren nach Anspruch 18, **dadurch gekennzeichnet, dass** der Anteil von TiCl₄ an der Prozessatmosphäre 0,9 Vol% bis 1,5 Vol% beträgt.

21. Verfahren nach Anspruch 19, **dadurch gekennzeichnet, dass** der Anteil von BCl₃ an der Prozessatmosphäre 0,05 Vol% bis 5 Vol% beträgt.

22. Verfahren nach Anspruch 19, **dadurch gekennzeichnet, dass** der Anteil von BCl₃ an der Prozessatmosphäre 0,09 Vol% bis 2,5 Vol% beträgt.

23. Verfahren nach Anspruch 15, **dadurch gekennzeichnet, dass** der Stickstoffgehalt der Prozessatmosphäre 14 Vol% bis 17 Vol% beträgt.

24. Verwendung eines Schneidkörpers nach Anspruch 1 zur Zerspanung von Stahlwerkstoffen.

25. Verwendung eines Schneidkörpers nach Anspruch 1 zur Zerspanung von Eisengusswerkstoffen und Graugusswerkstoffen.

## Claims

1. Cutter body in particular for workpiece machining,
with a base body, which has a coating, wherein the coating contains at least one TiBN layer with a boron content of more than or equal to 6 atom% and wherein the coating has been generated in a CVD process at temperatures from 700°C to 950°C, wherein the TiBN layer is a mixed phase layer only comprising TiN and TiB₂.

2. Cutter body according to claim 1, **characterised in that** the TiB₂ content of the mixed phase layer lies between 50% by wt. and 60% by wt.

3. Cutter body according to claim 1, **characterised in that** the TiBN layer is a TiN layer with intercalated TiB₂ crystals.

4. Cutter body according to claim 1, **characterised in that** the TiBN layer is a TiB₂ layer with intercalated TiN crystals.

5. Cutter body according to claim 1, **characterised in that** the TiBN layer is applied on a WC base material.

6. Cutter body according to claim 1, **characterised in that** the TiBN layer is provided as a covering material of a layered structure.

7. Cutter body according to claim 1, **characterised in that** the TiBN layer is applied to an Al₂O₃ layer.

8. Cutter body according to claim 1, **characterised in that** the base body is configured with a multilayered coating with the following layer sequence: TiN-TiCN-TiAlCNO-α-Al₂O₃-TiBN.

9. Cutter body according to claim 6, **characterised in that** the TiBN layer is the covering layer.

10. Cutter body according to claim 1, **characterised in that** the TiBN layer is a multilayered layer, in which the TiN layers alternate with TiBN layers.

11. Cutter body according to claim 10, **characterised in that** the total thickness of the TiBN layer amounts to 12 µm at maximum, and preferably amounts to between 2 µm and 5 µm.

12. Cutter body according to claim 1, **characterised in that** the TiN layers [of the] multilayered layer are thinner than the TiBN layers.

13. Cutter body according to claim 3, **characterised in that** the thickness of the TiN layers amounts at maximum to half the thickness of the TiBN layers.

14. Cutter body according to claim 1, **characterised in that** the multilayered layer has at least 20 layers.

15. Process for the production of a hard material layer, in particular for a cutter body, in which a body to be coated is positioned in a reactor at a process pressure between 60 and 950 mbar and a temperature between 700°C and 950°C, wherein the process atmosphere contains precursors for titanium and boron as well as nitrogen and/or nitrogen compounds.

16. Process according to claim 15, **characterised in that** the process temperature lies below 850°C.

17. Process according to claim 15, **characterised in that** the process atmosphere contains hydrogen (H₂).

18. Process according to claim 15, **characterised in that** the precursor for titanium is TiCl₄.

19. Process according to claim 15, **characterised in that** the precursor for boron is BCl₃.

20. Process according to claim 18, **characterised in that** the proportion of TiCl₄ in the process atmosphere amounts to 0.9 % by vol. to 1.5% by vol.

21. Process according to claim 19, **characterised in that** the proportion of BCl₃ in the process atmosphere amounts to 0.05% by vol. to 5% by vol.

22. Process according to claim 19, **characterised in that** the proportion of BCl₃ in the process atmosphere amounts to 0.09% by vol. to 2.5% by vol.

23. Process according to claim 15, **characterised in that** the nitrogen content of the process atmosphere amounts to 14% by vol. to 17% by vol.

24. Use of a cutter body according to claim 1 for machining steel materials.

25. Use of a cutter body according to claim 1 for machining cast iron materials and grey iron materials.

## Revendications

1. Corps de coupe, conçu en particulier pour l'usinage de pièces par enlèvement de copeaux, et comportant un corps substrat qui porte un revêtement, lequel revêtement, qui comprend au moins une couche de boronitrure de titane TiBN dont la teneur en bore est supérieure ou égale à 6 % en atomes, a été formé selon un procédé CVD mis en oeuvre à des températures de 700 à 950 °C, ladite couche de TiBN étant une phase mixte qui n'est constituée que de nitrure de titane TiN et de diborure de titane TiB₂.

2. Corps de coupe, conforme à la revendication 1, **caractérisé en ce que** la couche de phase mixte contient de 50 à 60 % en poids de TiB₂.

3. Corps de coupe, conforme à la revendication 1, **caractérisé en ce que** la couche de TiBN est une couche de TiN au sein de laquelle sont inclus des cristaux de TiB₂.

4. Corps de coupe, conforme à la revendication 1, **caractérisé en ce que** la couche de TiBN est une couche de TiB₂ au sein de laquelle sont inclus des cristaux de TiN.

5. Corps de coupe, conforme à la revendication 1, **caractérisé en ce que** la couche de TiBN est déposée sur un substrat en carbure de tungstène WC.

6. Corps de coupe, conforme à la revendication 1, **caractérisé en ce que** la couche de TiBN sert de matériau de couverture dans une structure en couches.

7. Corps de coupe, conforme à la revendication 1, **caractérisé en ce que** la couche de TiBN est déposée sur une couche d'alumine Al₂O₃.

8. Corps de coupe, conforme à la revendication 1, **caractérisé en ce que** le corps substrat présente une structure constituée de plusieurs couches empilées dans l'ordre suivant : TiN-TiCN-TiAlCNO-α-Al₂O₃-TiBN.

9. Corps de coupe, conforme à la revendication 6, **caractérisé en ce que** la couche de TiBN constitue la couche de couverture.

10. Corps de coupe, conforme à la revendication 1, **caractérisé en ce que** la couche de TiBN est une couche multi-feuillets dans laquelle des feuillets de TiN alternent avec des feuillets de TiBN.

11. Corps de coupe, conforme à la revendication 10, **caractérisé en ce que** l'épaisseur totale de la couche de TiBN vaut au plus 12 µm, et de préférence de 2 à 5 µm.

12. Corps de coupe, conforme à la revendication 10, **caractérisé en ce que** les feuillets de TiN de la couche multi-feuillets sont plus minces que les feuillets de TiBN.

13. Corps de coupe, conforme à la revendication 12, **caractérisé en ce que** l'épaisseur des feuillets de TiN vaut au plus la moitié de l'épaisseur des feuillets de TiBN.

14. Corps de coupe, conforme à la revendication 10, **caractérisé en ce que** la couche multi-feuillets comporte au moins 20 feuillets.

15. Procédé de préparation d'une couche de matériau dur, en particulier sur un corps de coupe, dans lequel un corps qu'on veut revêtir d'une telle couche est placé dans un réacteur, sous une pression opératoire de 60 à 950 mbar et à une température opératoire de 700 à 950 °C, dans une atmosphère opératoire qui contient des précurseurs de titane et de bore, ainsi que de l'azote et/ou des composés de l'azote.

16. Procédé conforme à la revendication 15, **caractérisé en ce que** la température opératoire est inférieure à 850 °C.

17. Procédé conforme à la revendication 15, **caractérisé en ce que** l'atmosphère opératoire contient de l'hydrogène H₂.

18. Procédé conforme à la revendication 15, **caractérisé en ce que** le précurseur de titane est du tétrachlorure de titane TiCl₄.

19. Procédé conforme à la revendication 15, **caractérisé en ce que** le précurseur de bore est du trichlorure de bore BCl₃.

20. Procédé conforme à la revendication 18, **caractérisé en ce que** l'atmosphère opératoire contient du tétrachlorure de titane en une proportion volumique de 0,9 à 1,5 %.

21. Procédé conforme à la revendication 19, **caractérisé en ce que** l'atmosphère opératoire contient du trichlorure de bore en une proportion volumique de 0,05 à 5 %.

22. Procédé conforme à la revendication 19, **caractérisé en ce que** l'atmosphère opératoire contient du trichlorure de bore en une proportion volumique de 0,09 à 2,5 %.

23. Procédé conforme à la revendication 15, **caractérisé en ce que** l'atmosphère opératoire contient de l'azote en une proportion volumique de 14 à 17 %.

24. Utilisation d'un corps de coupe, conforme à la revendication 1, pour détacher des copeaux de pièces en acier.

25. Utilisation d'un corps de coupe, conforme à la revendication 1, pour détacher des copeaux de pièces en fonte ou de pièces en fonte grise.
